# DEMANDE DE BREVET EUROPEEN

(11) **EP 1 467 605 A1**
(43) Date de publication de la demande: **13.10.2004**
(21) Numéro de dépôt: 04300163.5
(22) Date de dépôt: 24.03.2004
(51) Int. Cl.: H05K 3/34, B23K 35/38

(54) **Procédé et installation de brasage de composants électroniques par refusion limitant les phénomènes de basculement (effet Manhattan)**

(30) Priorité: 09.04.2003 FR 0304390
(71) Demandeur: L'Air Liquide S. A. à Directoire et Conseil de Surveillance pour l'Etude et l'Exploitation des Procédés Georges Claude, 75321 Paris Cedex 07 (FR)
(72) Inventeur: Dutournier, Bertrand L'Air Liquide S.A., 75321 cedex 07 Paris (FR)
(74) Mandataire: Mellul-Bendelac, Sylvie Lisette

(57) **Abrégé**

Un procédé de brasage par refusion de composants électroniques sur un support, du genre où l'on dispose d'alliage de brasure sur le support en des emplacements de connexion des composants ; on place les composants sur les emplacements de connexion et l'on effectue une opération de brasage proprement dite des composants par traitement thermique du support, par sa mise en contact, durant tout ou partie du traitement, avec une atmosphère de traitement qui comprend de la vapeur d'eau, la teneur en vapeur d'eau de l'atmosphère étant choisie en fonction de la nature des matériaux en présence afin d'homogénéiser substantiellement les vitesses de mouillage s'exerçant de chaque coté des composants.

## Description

La présente invention concerne le domaine du brasage de composants électroniques sur circuit.

On constate ces dernières années une évolution sensible de la taille des composants, surtout ceux dit « montés en surface », pour aller vers une miniaturisation constante, dictée par la recherche de l'intégration d'un maximum de composants dans un minimum de place.

Cette tendance a indiscutablement favorisé l'apparition de nouvelles difficultés pour les assembleurs de cartes électroniques dans leurs procédés de brasage par refusion.

En effet le poids du composant devenant négligeable par rapport au forces de mouillage agissant sur le composant lors de la phase de refusion, le phénomène de soulèvement ou de basculement de ce composant à la verticale de l'une de ses deux plages de report est couramment observé, si certaines précaution ne sont pas prises.

On rappellera ici que dans les procédés dits de « brasage par refusion », qui regroupe d'ailleurs sous ce vocable plusieurs techniques, on utilise une pâte à braser contenant l'alliage de brasure (formulation de pâte dans laquelle un flux de décapage est inclus) qui est déposée sur le support (circuit avant dépôt des composants, bords d'un boîtier d'encapsulation ou encore fond de boîtier), et à laquelle est apportée une certaine quantité de chaleur permettant d'obtenir la fusion de l'alliage métallique. Le plus souvent, ce transfert thermique est réalisé dans un four continu, à l'aide d'un profil thermique allant de la température ambiante à la température de fusion de l'alliage, suivie d'un refroidissement relativement brutal permettant de figer les soudures, et donnant lieu ainsi au pic de refusion (entourant la température de fusion de l'alliage) bien connu de l'homme du métier.

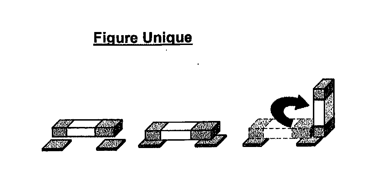

Le phénomène évoqué ci-dessus de soulèvement ou de basculement est le plus souvent appelé dans la littérature « effet MANATHAN » , ou « TOMBSTONING » ou encore « effet Menhir » car lorsque qu'il est présent sur plusieurs composants à la fois sur la carte, il fait penser à un ensemble de gratte-ciel vue d'avion (voir figure unique ci-dessous).

Ce phénomène de basculement des composants a été analysé et a fait l'objet d'une littérature extrêmement abondante. il est en général expliqué par un déséquilibre au niveau de la somme des moments de force agissant sur le composant lors de la refusion.

Dans le cas d'un mouillage simultané des deux plages d'accueil, il n'y a pas de cause initiale au soulèvement du composant.

Dans le cas d'un mouillage non simultané des deux plages d'accueil (résultant par exemple d'un écart de température entre les deux plages), une différence des moments de force peut dans certaines conditions conduire à un tel effet MANATHAN.

Ce déséquilibre a été notamment relié aux facteurs suivants :
- La forme des plages d'accueil, qui lorsqu'elles ne sont pas convenablement dessinées, vont accroître les moments de force, donc accroître la sensibilité à la différence de mouillage ;
- Le type de crème à braser, et en particulier la force des activateurs (flux), qui va influencer la vitesse de mouillage ;
- La quantité de crème à braser déposée (épaisseur et forme du dépôt, retrait par rapport aux bords de la plage d'accueil) ;
- La précision du placement du composant ;
- La forme du profil thermique de refusion, qui va conditionner la montée en température de l'ensemble plages d'accueil, crème à braser et composants, mais aussi conditionner le comportement des activateurs de la crème à braser, donc des vitesses de mouillage.

La littérature a généralement observé que l'utilisation d'une atmosphère inerte à base d'azote pour effectuer l'opération de brasage (atmosphère à base d'azote dont les vertus par ailleurs ont été largement démontrées en terme de qualité de brasage par la limitation des phénomènes d'oxydation) est ici un facteur aggravant dans la mesure où l'atmosphère à base d'azote accélère la vitesse de mouillage et accroît les forces de mouillage.

En pratique, les assembleurs sont alors contraints de s'imposer des tolérances drastiques sur chacun ou presque des paramètres listés plus haut, pour minimiser le phénomène, sans toutefois parvenir à totalement l'éliminer.

Dans ce contexte, l'un des objectifs de la présente invention est de proposer des conditions opératoires qui permettent d'améliorer les résultats du brasage de composants par refusion en diminuant notablement la survenue du phénomène d'effet MANATHAN (en permettant notamment d'élargir la fenêtre du procédé).

Pour cela, l'invention concerne un procédé de brasage par refusion de composants électroniques sur un support, du genre où l'on dispose d'alliage de brasure sur le support en des emplacements de connexion des composants ; on place les composants sur les emplacements de connexion et l'on effectue une opération de brasage proprement dite des composants par traitement thermique du support, par sa mise en contact durant tout ou partie du traitement avec une atmosphère de traitement qui comprend de la vapeur d'eau, la teneur en vapeur d'eau de l'atmosphère étant choisie en fonction de la nature des matériaux en présence afin d'homogénéiser substantiellement les vitesses de mouillage s'exerçant de chaque coté des composants.

Suivant des modes particuliers de réalisation de l'invention, celle-ci peut comporter l'une ou plusieurs des caractéristiques suivantes :
la teneur en vapeur d'eau de l'atmosphère de traitement est comprise dans la gamme [50 ppm, 10 %].
   - la teneur en vapeur d'eau de l'atmosphère de traitement est comprise dans la gamme [100 ppm, 1 %].
   - l'atmosphère de traitement est un gaz porteur d'azote comprenant la dite teneur en vapeur d'eau.
   - l'atmosphère de traitement comprend outre de la vapeur d'eau, de l'oxygène.
   - pour réaliser ledit traitement thermique, le support est porté à une température comprise entre la température ambiante et la température de fusion de l'alliage, et l'on réalise un zonage de l'atmosphère rencontrée successivement par le support le long du profil thermique appliqué par le fait que ladite atmosphère de traitement comprenant de la vapeur d'eau n'est mise en oeuvre que dans la zone de la température de fusion de l'alliage (« pic de refusion »).

La Demanderesse a ainsi pu démontrer que la présence de vapeur d'eau dans des proportions adaptées compte tenu du but recherché présentait au moi ns un double avantage :
- l'eau est un oxydant ce qui permet de ralentir la vitesse de mouillage. De plus, la cinétique d'oxydation est lente dans la gamme de température de travail généralement envisagée dans cette application de brasage par refusion ce qui limite les phénomènes d'oxydation au niveau des brasures (phénomènes d'oxydation qui ont déjà justifié dans cette technologie le passage du brasage sous air traditionnel à l'utilisation d'atmosphères à base d'azote).
- mais d'autre part l'eau possède une Enthalpie de vaporisation très élevée, permettant de transporter, et donc de transférer plus d'énergie que l'azote ou l'air seul, à volume constant.

On peut envisager selon l'invention différents modes de mise en oeuvre d'un tel dopage à la vapeur d'eau parmi lesquels :
- Une génération catalytique (et donc très précise) du point de rosée en question : en faisant réagir un mélange gazeux d'azote, d'oxygène , et d'hydrogène sur un catalyseur avant de l'injecter dans le four de refusion.
- Une génération du point de rosée par barbotage : tout ou partie du gaz vecteur (par exemple de l'azote) transite dans une cuve d'eau régulée en température, dans laquelle ce gaz vecteur va se charger en vapeur d'eau pour obtenir le point de rosé visé.
- L'injection directe d'eau liquide en un ou plusieurs points du four de refusion.

On va maintenant illustrer dans ce qui suit les résultats obtenus grâce à l'invention.

On a effectué des mesures comparatives de temps de mouillage sous différentes atmosphères à l'aide d'un meniscographe (Solder Paste tester) de la marque MALCOLM™.

La machine intègre une partie supérieure qui comprend un capteur de force et une pince porte-échantillon, et une partie inférieure qui par son enceinte chauffante permet de reproduire ce qui se déroule dans un four de refusion.

Cette enceinte est constituée en partie basse d'une plaque chauffante sur laquelle on dépose un support sérigraphié d'une quantité contrôlée de crème à braser et en partie haute d'un capot projetant un gaz dans la zone de test.

Un tel arrangement permet de tester sans difficultés différents types d'atmosphères.

A titre illustratif on donne ci-dessous les résultats comparatifs obtenus sous azote sec et azote saturé d'humidité à température ambiante (22000 ppm à environ 19°C).

Les conditions opératoires étaient alors les suivantes :
- crème à braser : crème ECOREL 803M de la marque PROMOSOL, épaisseur de sérigraphie = 200µm, surface de sérigraphie = 12x8 mm², insertion de l'échantillon dans la crème avant test = 50 µm.
- profil de température classique: durée totale = 175s, 1ere montée = 1,9°C/s, palier = 65s à 150°C, 2d montée = 2,6°C/s et pic de refusion = 215°C.
- support crème à braser : support en circuit imprimé double face 25x31 mm, conforme aux normes ULE41626, ASTM D 1867....
- échantillon de mesure : bande de cuivre LNE 8mm x 10mm.
- préparation de surface : conforme à la norme ISO 9455-16 i.e support grade 0, échantillon Grade IV soit une sulfuration contrôlée représentative d'un état de surface courant dans l'industrie pour mettre en évidence des différences de brasabilité.

On observe alors sous azote humide une augmentation de 12% de la valeur moyenne du temps de mouillage ce qui est tout à fait significatif.

## Revendications

1. Procédé de brasage par refusion de composants électroniques sur un support, du genre où l'on dispose d'alliage de brasure sur le support en des emplacements de connexion des composants ; on place les composants sur les emplacements de connexion et l'on effectue une opération de brasage proprement dite des composants par traitement thermique du support, par sa mise en contact, durant tout ou partie du traitement, avec une atmosphère de traitement qui comprend de la vapeur d'eau, la teneur en vapeur d'eau de l'atmosphère étant choisie en fonction de la nature des matériaux en présence afin d'homogénéiser substantiellement les vitesses de mouillage s'exerçant de chaque coté des composants.

2. Procédé de brasage selon la revendication 1, **caractérisé en ce que** la teneur en vapeur d'eau de l'atmosphère de traitement est comprise dans la gamme [50 ppm, 10 %].

3. Procédé de brasage selon la revendication 1 ou 2, **caractérisé en ce que** la teneur en vapeur d'eau de l'atmosphère de traitement est comprise dans la gamme [100 ppm, 1 %].

4. Procédé de brasage selon l'une des revendications précédentes, **caractérisé en ce que** l'atmosphère de traitement est un gaz porteur d'azote comprenant la dite teneur en vapeur d'eau.

5. Procédé de bra sage selon l'une des revendications précédentes, **caractérisé en ce que** l'atmosphère de traitement comprend outre de la vapeur d'eau, de l'oxygène.

6. Procédé de brasage selon l'une des revendications précédentes, **caractérisé en ce que** pour réaliser ledit traitement thermique, le support est porté à une température comprise entre la température ambiante et la température de fusion de l'alliage, et **en ce que** l'on réalise un zonage de l'atmosphère rencontrée successivement par le support le long du profil thermique appliqué par le fait que ladite atmosphère de traitement comprenant de la vapeur d'eau n'est mise en oeuvre que dans la zone de la température de fusion de l'alliage (« pic de refusion »).
